Europäisches Patentamt

European Patent Office

Office européen des brevets

(11) Publication number: **0 011 863**
**B1**

# EUROPEAN PATENT SPECIFICATION

(45) Date of publication of patent specification: **16.01.85**

(21) Application number: **79104761.6**

(22) Date of filing: **29.11.79**

(51) Int. Cl.⁴: **G 05 D 23/19,  G 05 B 11/28,
G 05 F 1/45,  H 03 K 5/156,
G 03 G 15/20**

(54) Current controller for an electrical load.

(30) Priority: **04.12.78 US 965880**

(43) Date of publication of application:
**11.06.80 Bulletin 80/12**

(45) Publication of the grant of the patent:
**16.01.85 Bulletin 85/03**

(84) Designated Contracting States:
**DE FR GB IT**

(56) References cited:
**US-A-3 491 283
US-A-3 681 581
US-A-3 878 358
US-A-3 961 236
US-A-4 115 860**

(73) Proprietor: **GENICOM Corporation
1 General Electric Drive Waynesboro
US-Virginia 22980-1999 (US)**

(72) Inventor: **Popelish, John Anthony
Box 160-A Route 1
Waynesboro, Virginia (US)**

(74) Representative: **Catherine, Alain
GETSCO 42, avenue Montaigne
F-75008 Paris (FR)**

Courier Press, Leamington Spa, England.

## Description

This invention relates to an apparatus for controlling electrical current supplied from an AC source to a load according to the precharacterizing part of claim 1. Such apparatus is described in US—A—3 878 358.

In the process of electrostatic or magnetic printing, information is typically recorded in the form of a latent electrostatic or magnetic image on a recording member with subsequent rendering of the latent image visible by the application of electrostatic and/or magnetic marking particles, commonly referred to as toner. The visual image can be either fixed directly upon the recording member or transferred from the member to a sheet of plain paper with subsequent affixing of the image thereto.

In order to permanently affix or fuse a toner material onto a record medium, such as paper, it is necessary to elevate the temperature of the toner material to a point at which the constituents of the toner material coalesce and become adhesive. This action causes the toner to be absorbed to some extent into the fibers of the record medium. Pressure is sometimes used to increase the adhesive. Thereafter, as the toner material is cooled, solidification of the toner material occurs causing the toner material to be firmly bonded to the record medium.

In both the electrostatic and magnetic printing arts, the use of thermal energy for fixing toner images onto a support member is old and well-known.

One approach to thermal fusing of toner images onto a record medium has been to pass the record medium with the toner images thereon between a pair of opposed rollers, at least one of which is either externally or internally heated. In this type of arrangement, the toner image contacts the surface of the heated roller member in the nip between rollers to thereby produce heating of the toner image within the nip.

In apparatus utilizing a fuser roller pair as described above, it is important that the heated roller surface be maintained within a suitable temperature range to properly fuse the toner image to its record medium. A conventional manner for accomplishing the foregoing is by the employment of a temperature sensitive device which is coupled to the heated roller and whose output controls the heat source.

Where AC power is involved the output either switches power on or off completely until the roller temperature reaches a desired level or switches different partial cycles of power as by a Silicon Controlled Rectifier (SCR) until the desired temperature level is reached.

These prior arrangements have exhibited shortcomings. Some of these have produced overshoots and undershoots of temperature beyond the desired narrow range of desirable temperatures. Others have generated objectionable high frequency noise or DC components in the power line, peak power requirements, transients, etc.

Ways to overcome these deficiencies in the prior art are proposed in the above mentioned US—A—3 878 358 and US—A—3 961 236. US—A—3 878 358 discloses an apparatus for controlling power to a heat source in accordance with the output value of a heat sensor. The control is accomplished by removing full cycles from a succession of alternating current cycles. US—A—3 961 236 discloses an apparatus for maintaining constant power consumption by monitoring fuser heater voltage and current and adjusting power supply. The adjustment is accomplished by controlling the number of supplied complete alternating current half-cycles, where switching of the current is being made at line voltage zero-crossings.

The problem addressed by the invention involves the avoidance of excessive electrical noise and DC components appearing in the power circuit, as well as the avoidance of current surges which would overload the power supply.

This problem is solved by the features of the characterizing part of claim 1.

Preferred embodiments of the invention are claimed in the sub-claims.

The invention insures that integral full cycles of alternating current flow in the power circuit, which may be approximately uniformly distributed in time, wherein a current sensor actuated control deletes some of the cycles of current flow when the load current is excessive.

If the invention is applied to temperature control of a thermal load, such as a fuser roller in a magnetic printer, there is provided a temperature sensor for providing analog signals representing the temperature of the fuser roller.

The invention, is treated in detail in the following description of a preferred embodiment of the invention when read in conjunction with the accompanying drawings wherein:

FIGURE 1 is a pictorial view of a toner sealing mechanism for an automatic electrostatic or magnetic printing apparatus utilizing the present invention;

FIGURE 2 illustrates graphically certain features useful in explaining the present invention;

FIGURE 3 is a schematic view, partly in section, of a curie point temperature sensing system incorporated in the apparatus of FIGURE 1;

FIGURE 4 is a block diagram of a roller temperature control used in conjunction with the fuser apparatus illustrated in FIGURE 1;

FIGURE 5 is waveforms illustrating certain aspects of the operation of the present invention;

FIGURE 6 illustrates in greater detail certain blocks illustrated in FIGURE 4;

FIGURE 7 illustrates the power waveforms generated in accordance with the present invention; and

FIGURE 8 illustrates the details of the line current sensing system shown in FIGURE 4.

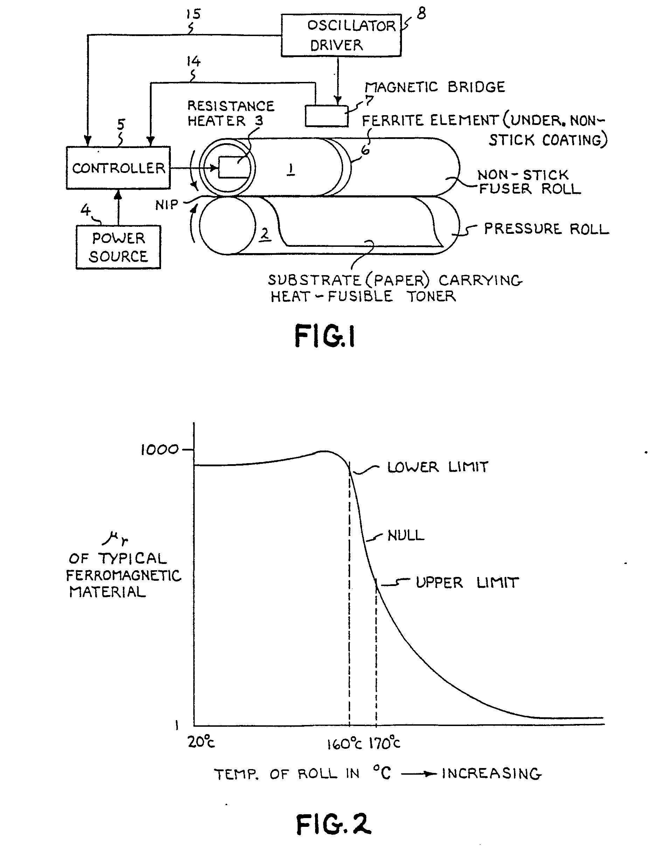

Referring now to FIGURE 1, there is shown an embodiment of the subject invention as applied in a magnetic printing system wherein latent magnetic images are produced on a magnetic medium such as an endless belt of magnetic tape and the latent magnetic images are developed with toner particles which are then transferred to a record medium such as paper. In a printer application the latent images would be descriptive of, for example, alpha and numeric information available from a keyboard or from a communication line. In order to provide a permanent record, it is desirable that the toner developed images transferred to the record medium are permanently fused to that record medium. In this connection shown in FIGURE 1, a pair of rollers 1 and 2 are provided. The two rollers driven by an external source such as a motor, not shown, cooperate with one another to form a nip therebetween through which a substrate such as paper, supporting toner material, is moved. As shown in FIGURE 1, roller 1 is heated by a resistance heater 3 such as a quartz lamp. In the embodiment shown, the heater derives electrical energy from source 4 under the control of a controller 5 which shall be described in greater detail shortly. The surface temperature of roller 1 must be maintained within a very narrow range of the order of 20°F (10°C) typically centered at 330°F (165°C) to render the toner particles adhesive enough to cling to the paper but not hot enough to melt them to a liquid which would leave a residue clinging to the roller and affecting subsequent paper passing between the rollers. To achieve this, therefore, the electrical energy supplied to resistance heater 3 has to be controlled very closely. In order to achieve this degree of control, it is necessary to measure or monitor the temperature of the surface of roller 1 very accurately. In order to monitor the surface temperature of roller 1, applicant inserts a ferromagnetic material as a band 6 completely surrounding the roller. The composition of the material is selected to have a curie temperature range which corresponds to range of temperature to be maintained.

Referring to FIGURE 2, there is shown a characteristic curve for curie point material operating in the embodiment of the present invention. In FIGURE 2 the magnetic relative permeability which is a dimensionless number is plotted as the ordinate and the temperature of the material is plotted as the abscissa. As shown, the permeability of the material is in the order of 1000 for all temperatures starting from room temperature 70°F (20°C) up to some point near a control point where the permeability of the material drops rapidly through a range which includes the temperature control range. As previously mentioned in a particular embodiment, this temperature control range was relatively narrow and of the order of 20°F (10°C) centered on 330°F (165°C). While the invention has been described in connection with a particular temperature control range in mind, it is obvious that this range can be changed depending on the application desired. FIGURE 2, therefore, illustrates that it is desired to control the temperature of the roller 1 within the narrow temperature range of 20°F (10°C). To achieve this, applicant makes use of an alternating magnetic field bridge having the curie point material included in one arm of said bridge. As shown in FIGURE 1 the magnetic bridge is energized by an oscillator driver 8 which in a particular application provided 3 kilohertz signals to the bridge. The output of the bridge representative of the permeability of the material as it changes with temperature, and hence the representative of the surface temperature of roller 1, constitutes an input signal to controller 5 for controlling the amount of electrical energy being supplied by source 4 to the heater 3 to maintain the temperature of the surface of the roller within the desired limits.

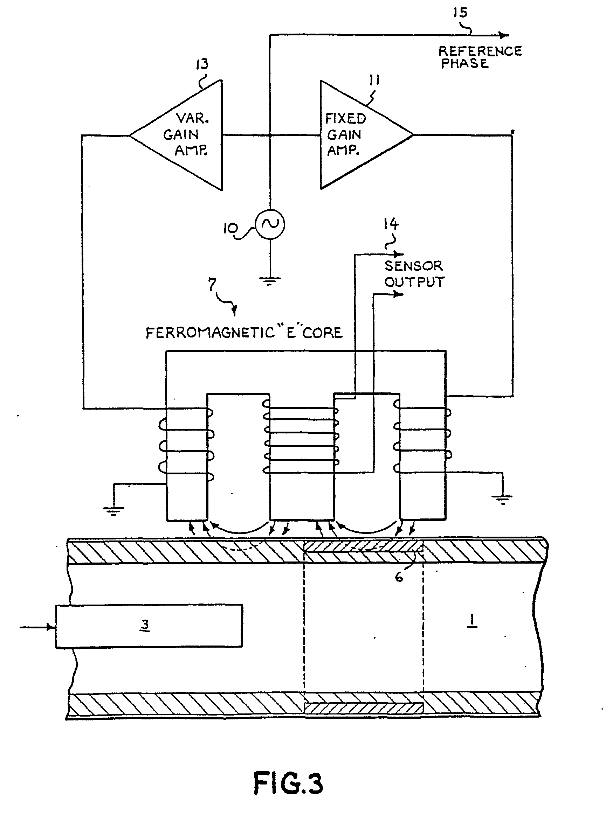

Referring to FIGURE 3, there is shown in greater detail the nature of the magnetic bridge with the roller 1 shown in cross section. Roller 1 comprises an aluminum cylindrical core coated with a thin, elastomeric, non-stick coating. Bridge 7 in a particular embodiment comprises an E core of ferromagnetic material in which the reference winding energizes one arm of the bridge from signals applied from oscillator 10 via amplifier 11. The opposite arm of the bridge is energized from the source 10 through a variable gain inverting amplifier 13. Inverting amplifier 13 is such that the windings 9 and 12 are energized with 3 kilohertz signals which are 180° out of phase. The gain of the variable gain amplifier 13 is adjusted such that the bridge passes through null at the center of the temperature or permeability control range. One of the arms of the bridge includes, the roller 1 without the ferrite material, that is containing in a particular embodiment only aluminum which exhibits an essentially constant permeability with temperature change and the other arm includes the portion of the roller 1 carrying the ferrite material 6 embedded in a surface which has a permeability which varies with the temperature of the surface of the roller. The magnetic fields established between the arms of the bridge and the fuser roller are illustrated for one particular instant by the arrows. Since the ferromagnetic material was selected to have its steepest permeability changes in the range of the temperature control range, the bridge produces signals on its output leads 14 which essentially represents the temperature of the roller in the desired control range. The signals developed on the output leads 14 are of 3 kilohertz value and having a phase which varies with respect to the phase of the signals from source 10 available on leads 15 in accordance with the change in permeability of the ferrite material 6 and hence of the temperature of the surface of the roller 1. Controller 5 in FIGURE 1 responds to the relative phase of the signals available on 14 from the bridge and 15 from the reference source 10 to control the electrical energy available from source 4 to the heater 3. The controller to be described shortly performs several complex functions necessary to maintain the surface temperature of the roller within the prescribed temperature range while at the same time minimizing the adverse impact on the power source 4 as a result of the characteristics of the heater element 3. For example, in a particular embodiment the heater element was a quartz lamp which had a maximum power consumption of 2000 watts when provided with power from 120 volts 60 hertz source. With this power, the lamp can raise the surface temperature of the fuser roller 1 to a level which will soften the toner and cause proper adhesion of the toner to the record medium or paper. It should be noted that in a high speed printer application a considerable amount of heat energy has to be supplied to the fuser roller since the heat energy is being carried away rapidly by the paper moving therethrough. In a particular application where the paper moved at about 16 inches (40 cm) per second, a high power quartz lamp was required and this lamp had to be operated near its maximum limit. When such a high power lamp is initially energized, a current surge develops, typically six times normal heating current due to the large positive temperature coefficient of resistance of the lamp filament. In a usual application this amount of surge current would open the fuses or require an oversized power source. To minimize this surge current, it is necessary to allow the filament to warm up slowly by applying widely spaced individual cycles of the current thereto. Also since the typical lamp current is near the source limit, a current detector is included to delete cycles to limit the full power current as it approaches an acceptable maximum. Random switching this large amount of power in an application such as involving a printer connected to normal AC service would produce high frequency noise or DC components in the power line circuit which would exceed acceptable limits. To overcome these problems, applicant provides an arrangement to control the applied power as integral cycles rather than applying fractional parts of line frequency. Power is therefore controlled in full integral cycle increments. This involves switching at the zero crossings of the line voltage. In order to avoid multiple cycle surges during the cycle switching, the arrangement to be described balances the power cycles (makes them integral cycles) and distributes them evenly in time as the proportion of cycles blocked to cycles passed in varied in accordance with the energy requirements of the fuser roller 1.

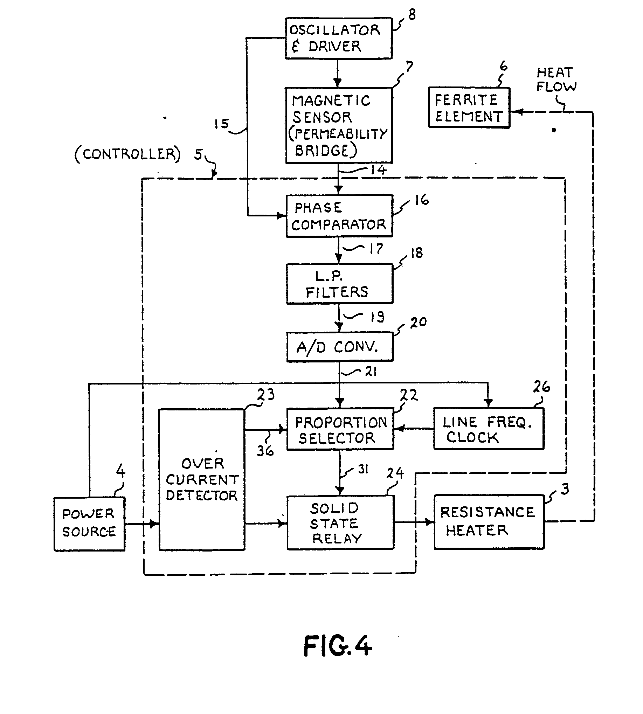

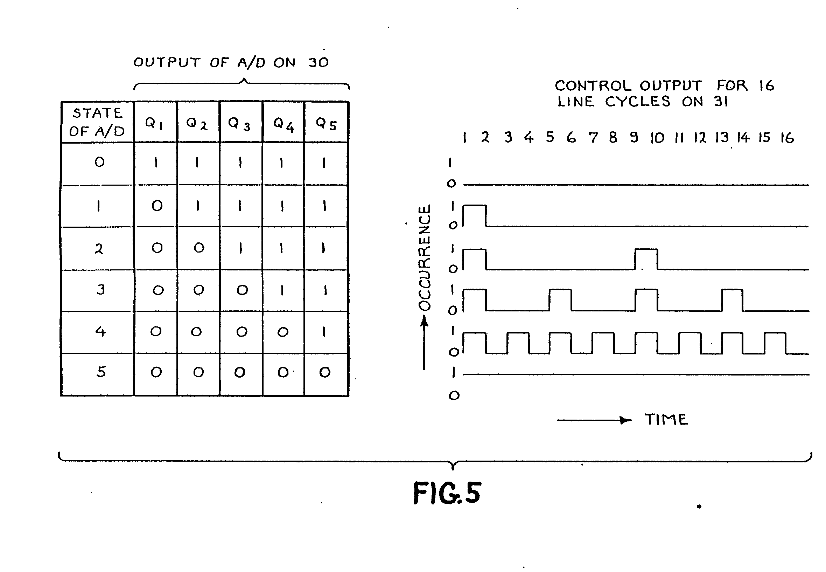

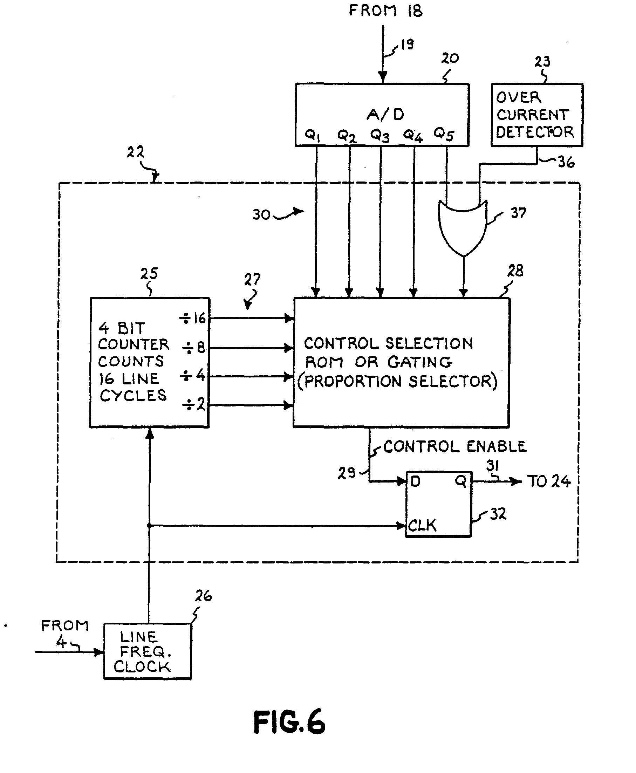

Referring to FIGURE 4, a phase comparator 16 responds to the difference in phase between the signals available on leads 14 and 15 to produce an output signal on lead 17 indicative of the difference in phase between the applied input signals. In a particular embodiment the signals on leads 14 and 15 were 3 kilohertz sine waves. These 3 kilohertz input signals are first prepared by amplification and limiting to produce square waves which are combined in an exclusive OR gate as digital pulses. When these processed pulses are in the same state, the output of comparator 16 is at a logic 0 state and if they are not in the same state, then they produce a second state output signal which is at a logic 1. This circuit is a well known circuit and for further details reference should be made to the RCA solid state handbook entitled "COS/MOS Integrated Circuits" dated 1977 wherein an exclusive OR network operating as a phase comparator is described on page 612. The output of comparator 16 is level 1 or level 0 signals for various amounts of time depending upon the relative phases of the signals available on leads 14 and 15. The purpose of circuit 18 is to convert the variable duty cycle pulse train available on lead 17 to a DC signal by low pass filtering. The DC signal, therefore, on lead 19 is indicative of the temperature of the surface of the fuser roller 1. The function of block 20 is to convert the analog signal on lead 19 to a digital signal in form of a binary code representing the quantized value of the DC signal available on 19. Essentially, circuit 20 senses five discrete DC levels and produces a binary code on lead 21. The A to D converter 20 is a common circuit and will not be described in detail. Reference can be made to Texas Instruments' integrated circuit TL489. Reference can be made now to FIGURE 5 wherein the output of the A to D converter in the form of a five bit code is shown. The converter has six possible output states which span the range of analog signals available on lead 19. The 0 state represents the upper limit of the temperature control range shown in FIGURE 2 and the state 5 represents the lower limit of the temperature control range. The proportion selector 22 functions to delete the desired integral number of power cycles being supplied from the power source 4 to the resistance heater 3 through a current detector 23 and solid state relay 24 to the resistance heater 3. As previously mentioned, the function of the selector 22 is to control solid state relay 24 so that it only supplies full or integral cycles of power and that the cycles passed are uniformly distributed in time. Referring to FIGURE 6 the further details of the selector 22 are shown. Essentially, this involves a four bit counter 25 which counts the clock pulses available from source 26 and develops a binary number representative of the sequential counting from 1 to 16 on the leads 27 applied to gates 28. The inputs to leads 27 are representative of the counted line cycles. The particular line cycles selected for passage to heater 3 are communicated to lead 29 in accordance with the states of the signals available on leads 30 from the A to D converter 20.

Referring to FIGURE 5 again therefore, it is seen that for the 0 states no integral or full cycles of the 16 counted cycles is passed to the output lead 31. For the first state only the first cycle is passed. For the second state only the first and ninth cycles are passed and so forth. For the fourth state alternate cycles are passed and for the fifth state the power is passed continuously for all cycles. Flip-flop 32 assures that only one on-off decision can be made per cycle. Flip-flop 32 is a standard D type flip-flop. This decision is conveyed by a signal developed on lead 31 for coupling to 24. These variations in duty cycle represents the various amounts of average power to be delivered from source 4 to the resistance heater 3 to maintain the temperature of the roller 1 within the desired range under varying load conditions.

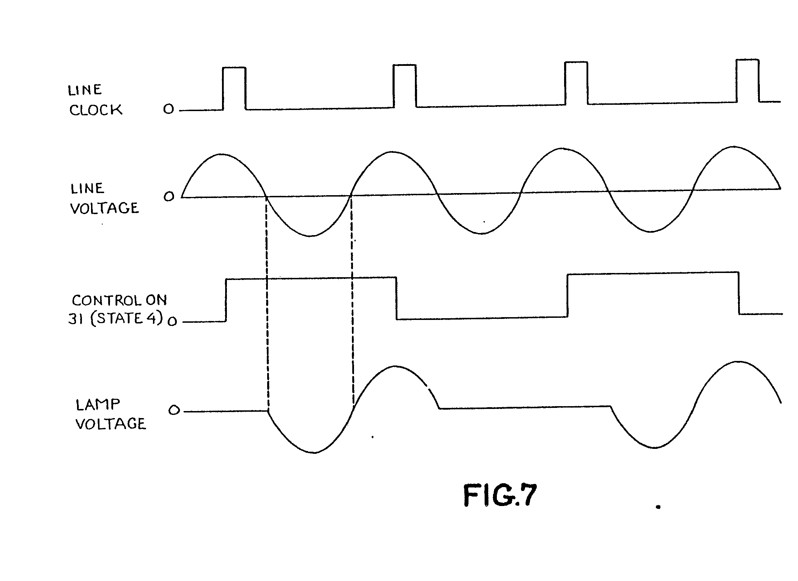

Referring to FIGURE 7, the manner in which the solid state relay 24 responds to the control signal available on lead 31 to gate the desired integral cycles from the power source 4 to the resistance heater 3. This is shown for the condition of A/D state 4 appearing on leads 30. Thus, applicant has described an arrangement for either applying or deleting integral full cycles of power from the source to control the heating of the roller while uniformly distributing the power line cycles so that they produce the previously mentioned advantages.

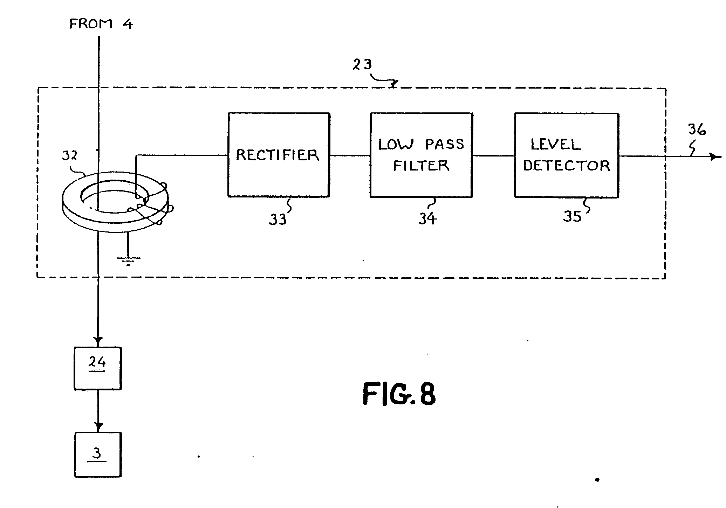

It is desirable to monitor the average line current from source 4 to the resistance heater 3 and to delete cycles to reduce excessive current consumption during full power, or state 5, caused by high line voltage conditions or by an unusually low resistance of the heater 3 which would otherwise cause the heater circuit to draw excessive current and open the fuse. The over current detector 23 operates to cause the proportion selector 22 to delete alternate cycles (state 4 of FIGURE 5) to reduce the current consumption during the period these undesirable conditions exist. In a particular application the current detector 23 comprises a current sensor, i.e. transformer 32 as shown in FIGURE 8 which responds to the current flowing in the AC line from source 4 to resistance heater 3. Current produced by sensor 32 is rectified in full wave detector 33 and filtered in low-pass filter 34 to produce a signal corresponding to the average magnitude of lamp current. When this signal at the output of the low pass filter 34 is above a predetermined level indicating excessive current, a level detector 35 responds to produce a signal over lead 36 to the OR gate 37 of the proportion selector 22 to change the state 5 signals appearing on leads 21 to a state 4. This state 4 represents the application of alternate integral cycles of power from source 4 to the resistance heater. This condition is continued until the average current from the low pass filter 34 falls below the predetermined level which indicates that the adverse conditions have passed.

The solid state relay 24 is a common device available usually as a triac switching element with an internal triggering circuit to accomplish switching at the zero crossing points of the applied voltage following changes in the control signal.

While the invention has been described with particular reference to the construction shown in the drawings, it is understood that further modification may be made without departing from the invention as claimed.

**Claims**

1. Apparatus for controlling electrical current supplied from an AC source (4) to a load (3) in accordance with an analog control signal representing a variable characteristic of said load, comprising means (20) for quantizing said analog control signal into digital signal, means (22) for controlling the proportion of integral cycles of alternating current from said source (4) blocked to those supplied to said load (3) in accordance with said digital signal and for providing a uniform spacing in time of the integral cycles supplied to said load (3), characterized by means (32, 33, 34) for indicating the average current consumed by said load (3), means (35) responsive to said indicated average current exceeding a predetermined level for providing a second control signal, and means (37) for modifying said digital signal in accordance with said second control signal in such a way that some of said current cycles are deleted.

2. Apparatus according to claim 1, characterized in that said analog signal is a DC signal and said means (20) for quantizing senses a plurality greater than two of discrete DC signal amplitude levels to produce a corresponding plurality of discrete digital signals, said means (22) for controlling is responsive to said digital signals to produce a corresponding plurality of discrete duty cycles from said source (4), and said means (37) for modifying causes said means (22) for controlling to change production of a duty cycle to a lower duty cycle.

3. Apparatus according to claim 2, characterized in that said means (22) for controlling comprises a counter (25) for counting frequency cycles of said AC source (4) to provide count signals, that switch means (24) are provided for passing and blocking the application of power from said AC source (4) to provide count signals, that switch means (24) are provided for passing and blocking the application of power from said AC source (4) to said load circuit (3), and that means (28) responsive to said digital signals control the gating of desired count signals to said switch means (24) for controlling the duty cycle of power supplied from said source (4) to said load (3).

**Patentansprüche**

1. Einrichtung zum Regeln des elektrischen Stromes, der von einer Wechselstromquelle (4) einer Last (3) gemäß einem analogen Steuersignal zugeführt wird, das eine variable Kenngröße der Last darstellt, mit Mitteln (20) zum Quantifizieren des analogen Steuersignales in ein digitales Signal, Mitteln (22) zum Steuern des Anteiles der integralen Schwingungen des gesperrten Wechselstromes aus der Quelle (4) zu demjenigen, der der Last gemäß dem digitalen Signal zugeführt wird, und zum Liefern einer gleichförmigen zeitlichen Beabstandung der der Last (3) zugeführten integralen Schwingungen, gekennzeichnet durch Mittel (32, 33, 34) zur Anzeige des mittleren, durch die Last verbrauchten Stromes, Mittel (35), die auf den angezeigten mittleren Strom, der einen vorbestimmten Wert überschreitet, ansprechen zur Lieferung eines zweiten Steuersignales, und Mittel (37) zum Verändern des digitalen Signales gemäß dem zweiten Steuersignal derart, daß einige der Stromschwingungen beseitigt sind.

2. Einrichtung nach Anspruch 1, dadurch gekennzeichnet, daß das analoge Signal ein Gleichstromsignal ist und die Quantifizierungsmittel (20) eine Anzahl von mehr als Zwei diskreten Gleichstromsignal-Amplitudenwerten abtasten zur Erzeugung einer entsprechenden Anzahl von diskreten digitalen Signalen, die Steuermittel (22) auf die digitalen Signale ansprechen zur Erzeugung einer entsprechenden Anzahl von diskreten Schwingungen aus der Quelle (4), und die Änderungsmittel (37) bewirken, daß die Steuermittel (22) weniger Schwingungen erzeugen.

3. Einrichtung nach Anspruch 2, dadurch gekennzeichnet, daß die Steuermittel (22) einen Zähler (25) zum Zählen der Schwingungen der Wechselstromquelle (4) zur Lieferung von Zählsignalen aufweisen, eine Schalteinrichtung (24) vorgesehen ist zum Durchlassen und Sperren der Leistung von der Wechselstromquelle (4) zur Last (3) und auf die digitalen Signale ansprechende Mittel (28) die Zufuhr von gewünschten Zählsignalen zu der Schalteinrichtung (24) steuern zum Steuern der der Last (3) von der Quelle (4) zugeführten Leistung.

**Revendications**

1. Dispositif de réglage d'un courant électrique fourni à partir d'une source de courant alternatif (4) à une charge (3) selon un signal de réglage analogique représentant une caractéristique variable de la charge, comprenant un moyen (20) pour quantifier ce signal analogique de réglage en signal numérique, un moyen (22) pour régler le rapport entre le nombre de cycles entiers de courant alternatif de la source (4) bloqués et le nombre de ceux fournis à la charge (3) selon le signal numérique et pour fournir une répartition uniforme dans le temps des cycles entiers fournis à la charge (3), dispositif caractérisé en ce qu'il comporte des moyens (32, 33, 34) pour indiquer le courant moyen consommé par la charge (3), un moyen (35) sensible au dépassement par ce courant moyen indiqué d'un niveau prédéterminé pour fournir un deuxième signal de commande, et un moyen (37) pour modifier le signal numérique en fonction du deuxième signal de commande de sorte que certains des cycles de courant sont supprimés.

2. Dispositif selon la revendication 1 caractérisé en ce que le signal analogique est un signal de courant continu et que le moyen (20) quantitatif détecte un nombre supérieur à deux de niveaux d'amplitude de signaux discrets de courant continu pour fournir une série correspondante de signaux numériques discrets, en ce que le moyen (22) de réglage est sensible à ces signaux numériques pour fournir une série correspondante de rapports cycliques discrets de la source (4), et en ce que le moyen (37) de modification provoque la modification par le moyen de réglage (22) de la réalisation d'un rapport cyclique en un rapport cyclique plus faible.

3. Dispositif selon la revendication 2 caractérisée en ce que le moyen (22) de réglage comporte un compteur (25) pour compter la fréquence des cycles de la source de courant alternatif (4) pour fournir des signaux de comptage, en ce que des moyens de commutation (24) sont fournis pour laisser passer ou bloquer le courant de la source de courant alternatif vers le circuit de la charge (3), et en ce que les moyens (28) sensibles aux signaux numériques commandent le passage des signaux dénombrés voulus vers le moyen de commutation (24) pour régler le rapport cyclique de courant fourni par la source (4) à la charge (3).

**0011863**

FIG.1

FIG.2

**0011863**

FIG.3

FIG.4

OUTPUT OF A/D ON 30

| STATE OF A/D | $Q_1$ | $Q_2$ | $Q_3$ | $Q_4$ | $Q_5$ |
|---|---|---|---|---|---|
| O | 1 | 1 | 1 | 1 | 1 |
| 1 | O | 1 | 1 | 1 | 1 |
| 2 | O | O | 1 | 1 | 1 |
| 3 | O | O | O | 1 | 1 |
| 4 | O | O | O | O | 1 |
| 5 | O | O | O | O | O |

CONTROL OUTPUT FOR 16
LINE CYCLES ON 31

1 2 3 4 5 6 7 8 9 10 11 12 13 14 15 16

OCCURRENCE

TIME

FIG.5

FROM 18

19

20

23

| A/D |
| $Q_1$ $Q_2$ $Q_3$ $Q_4$ $Q_5$ |

OVER
CURRENT
DETECTOR

22

36

30

37

25

27

28

| 4 BIT<br>COUNTER<br>COUNTS<br>16 LINE<br>CYCLES | ÷16<br>÷8<br>÷4<br>÷2 |

CONTROL SELECTION
ROM OR GATING
(PROPORTION SELECTOR)

CONTROL ENABLE

29

31

D    Q    TO 24

CLK    32

26

FROM
4

LINE
FREQ.
CLOCK

**FIG.6**

LINE CLOCK

LINE VOLTAGE

CONTROL ON 31 (STATE 4)

LAMP VOLTAGE

0011 863

FIG.7

FROM 4

FIG.8